# EUROPEAN PATENT APPLICATION

(11) **EP 4 549 527 A1**
(43) Date of publication of application: **07.05.2025**
(21) Application number: 24210857.9
(22) Date of filing: 05.11.2024
(51) Int. Cl.: C09G 1/02, C09K 3/14

(54) **POLISHING COMPOSITION FOR A SEMICONDUCTOR PROCESS AND MANUFACTURING METHOD OF SUBSTRATE USING THE SAME**

(30) Priority: 06.11.2023 KR 20230151793
(71) Applicant: SK enpulse Co., Ltd., Pyeongtaek-si, Gyeonggi-do 17784 (KR); SK Hynix Inc., Icheon-si, Gyeonggi-do 17336 (KR)
(72) Inventor: HAN, Deok Su, 03142 Seoul (KR); CHO, Jong Young, 17336 Icheon-si, Gyeonggi-do (KR); KIM, Woo Joo, 17336 Icheon-si, Gyeonggi-do (KR); KANG, Hyun Goo, 17336 Icheon-si, Gyeonggi-do (KR); LEE, Dong Kyun, 17336 Icheon-si, Gyeonggi-do (KR)
(74) Representative: BCKIP Part mbB

(57) **Abstract**

A polishing composition for a semiconductor process according to one embodiment of the present disclosure includes a polishing particle and a corrosion inhibitor. The corrosion inhibitor includes a first corrosion inhibitor, which is an amino azole-based compound and a second corrosion inhibitor, which is a diazole-based compound. The polishing composition for a semiconductor process has a pH of 2 to 5. A static etch rate for a tungsten film of the polishing composition for a semiconductor process is 6 Å/min or less.

When polishing a substrate comprising a tungsten film and the silicon oxide film, such a polishing composition may provide a defect-reduced polished surface while exhibiting excellent polishing rate for a silicon oxide film.

## Description

This application claims the priority of Korean Patent Application No. 10-2023-0151793 filed on November 6, 2023.

### BACKGROUND

### 1. Field

The present disclosure relates to a polishing composition for a semiconductor process and a method of manufacturing a substrate using the same.

### 2. Description of the Related Art

As semiconductor devices are becoming finer and denser, finer patterning techniques are being employed, resulting in complex surface structures of semiconductor devices and frequent defects due to interlayer film steps. In the manufacture of semiconductor devices, chemical mechanical polishing (CMP) is used as a planarization technique to remove steps in certain films formed on the substrate.

In the CMP process, a substrate is pressed and rotated against a polishing pad while a slurry is applied to the pad to polish the surface. The properties of the slurry used vary depending on a target to be polished in the stage of the semiconductor device fabrication process.

Polishing after forming a metal wiring requires sufficient polishing rate and flatness while minimizing dishing or erosion.

### SUMMARY

A polishing composition for a semiconductor process according to one embodiment of the present disclosure includes a polishing particle and a corrosion inhibitor.

The corrosion inhibitor includes a first corrosion inhibitor, which is an amino azole-based compound, and a second corrosion inhibitor, which is a diazole-based compound.

The polishing composition for a semiconductor process has a pH of 2 to 5.

A static etch rate for a tungsten film of the polishing composition for a semiconductor process is 6 Å/min or less.

I_{corr}, a corrosion current density for a tungsten film of the polishing composition for a semiconductor process may be 60 µA/cm² or less.

E_{corr}, a corrosion potential for a tungsten film of the polishing composition for a semiconductor process may be -30 mV or more.

The polishing composition for a semiconductor process may include the corrosion inhibitor of 0.07 wt% to 3 wt%.

A ratio of a content (by weight) of the second corrosion inhibitor to a content (by weight) of the first corrosion inhibitor may be 0.6 to 2.0.

The corrosion inhibitor may inhibit corrosion of a tungsten film.

The polishing composition for a semiconductor may further include a fluorine-based surfactant.

The polishing composition for a semiconductor process may include the fluorine-based surfactant of 10 ppm (by weight) to 500 ppm (by weight).

A polishing selectivity ratio of a silicon oxide film to a tungsten film of the polishing composition for a semiconductor process may be 5 or more.

A method of manufacturing a substrate according to another embodiment of the present disclosure includes polishing a substrate by applying the polishing composition for a semiconductor process as a slurry.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of this disclosure. For example, the sequences of operations described herein are merely examples, and are not limited to those set forth herein, but may be changed as will be apparent after an understanding of this disclosure, with the exception of operations necessarily occurring in a certain order. Also, descriptions of features that are known in the art may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of this disclosure. Hereinafter, while embodiments of the present disclosure will be described in detail, it is noted that examples are not limited to the same.

As used herein, the terms "about," "substantially," and the like are meant to be used at or near the numerical value when manufacturing and material tolerances inherent in the recited meanings are presented, and to aid in the understanding of the present disclosure, and to prevent unscrupulous infringers from taking unfair advantage of the disclosure where precise or absolute numerical values are recited.

Throughout the disclosure, the term "combination thereof" as used in a Markush-style representation means one or more mixtures or combinations selected from the group of components described in the Markush-style representation and includes one or more selected from the group of components.

Throughout the disclosure, references to "A and/or B" shall mean "A, B, or A and B".

Throughout the disclosure, terms such as "first", "second" or "A", "B" are used to distinguish one from the other unless otherwise indicated.

As used herein, "B being placed on A" means that B is or may be placed on A, with or without other layers located therebetween, and is not to be construed as limited to B being located abutting the surface of A.

In this specification, singular expressions shall, unless otherwise indicated, be construed to include the singular or plural as construed from the context. "~-based compound" includes "~-compound" and derivatives thereof.

A substrate comprising a tungsten film and an insulating film may be polished by applying a slurry having a high polishing selectivity ratio of the insulating film to the tungsten film. During the polishing process, defects resulted from corrosion of the tungsten film may occur. These defects tend to occur more frequently when polishing compositions having a low pH are applied.

The inventors of the present disclosure applied a corrosion inhibitor comprising a first corrosion inhibitor and a second corrosion inhibitor to the polishing composition and adjusted the static etch rate for the tungsten film of the polishing composition. Through this, the inventors experimentally found that it is possible to effectively inhibit the corrosion of tungsten films even under low pH conditions. Furthermore, they found the polishing composition may exhibit excellent polishing property for a silicon oxide film and completed the present disclosure.

Below, the present disclosure is described.

A polishing composition for a semiconductor process in the present disclosure includes a polishing particle and a corrosion inhibitor.

### Property of the Polishing Composition

In the present disclosure, along with controlling the pH of the polishing composition within a preset range, a static etch rate for the tungsten film may be also controlled. This may improve polishing properties for the silicon oxide film of the polishing composition, while reliably inhibiting corrosion of the tungsten film by the acidic polishing composition.

The static etch rate for tungsten films is measured as follows. The substrate on which the tungsten film is formed is immersed in the polishing composition for 10 minutes. Thickness difference between the tungsten film before and after immersion is then measured, and the thickness difference is divided by the immersion time to calculate the static etch rate.

The pH of the polishing composition is measured with a pH meter.

The polishing composition for a semiconductor process has a pH of 2 to 5. The pH may be from 2.5 to 5. The pH may be 3 or more. The pH may be 3.5 or more.

The static etch rate for the tungsten film of the polishing composition may be 6 Å/min or less. The static etch rate may be 5 Å/min or less. The static etch rate may be 4 Å/min or less. The static etch rate may be greater than or equal to 0.1 Å/min.

In this case, the polishing selectivity of the silicon oxide film to the tungsten film of the polishing composition is improved, and the oxidation rate of the tungsten film exposed to the polishing composition is controlled to inhibit excessive damage at the tungsten film during the polishing process.

In the present disclosure, I_{corr}, the corrosion current density for the tungsten film in the polishing composition may be controlled to help reduce the amount of corrosion at the tungsten film exposed to the polishing composition below a certain level.

The I_{corr} for the tungsten film of the polishing composition may be 60 µA/cm² or less. The I_{corr} may be 40 µA/cm² or less. The I_{corr} may be 30 µA/cm² or less. The I_{corr} may be 20 µA/cm² or less. The I_{corr} may be 1 µA/cm² or more. In such cases, the degree of damage of the tungsten wiring during the polishing process may be reduced.

In the present disclosure, E_{corr}, the corrosion potential of the polishing composition may be adjusted to control the point at which the tungsten film begins to be corroded during the polishing process.

E_{corr}, the corrosion potential for the tungsten film of the polishing composition may be greater than or equal to -30 mV. The E_{corr} may be greater than or equal to -25 mV. The E_{corr} may be -20 mV or more. The E_{corr} may be -15 mV or more. The E_{corr} may be +20 mV or less. In such cases, surface of the tungsten film in surface to be polished may be polished even more flat by polishing, and excessive erosion of the tungsten film by the polishing composition may be suppressed.

The corrosion current density I_{corr} and the corrosion potential E_{corr} for the tungsten film are measured with a Potentiostat. The measurement conditions for I_{corr} and E_{corr} are set as follows.
- Reference Electrode: SCE (Saturated Calomel Electrode) with saturated KCl
- Working Electrode Type: Solid Tungsten Electrode
- RED Speed: 0 volt
- Working Electrode Area: 1cm2
- Measured Open Circuit: 131.27mV

### Endpoint Properties

- Initial Potential: -1.5V (vs OC)
- Final Potential: 4V (vs Ref)

### Scan Properties

- Step Height: 10mV
- Step Time: 1s
- Smay Rate: 10mV/s
- Total Points: 551

For example, I_{corr} and E_{corr} may be measured with the versaSTAT 4 model from AMETEK Scientific instruments.

The electrical conductivity of the polishing composition for a semiconductor process may be 20 µS/cm or more. The electrical conductivity may be 40 µS/cm or more. The electrical conductivity may be 70 µS/cm or more. The electrical conductivity may be 400 µS/cm or less. The electrical conductivity may be 300 µS/cm or less. The electrical conductivity may be 200 µS/cm or less. In such cases, it is possible to prevent excessive damage to the tungsten film due to chemical reactions during the polishing process, while allowing the polishing composition to effectively polish surface to be polished at an excellent polishing speed.

A zeta potential of the polishing composition for a semiconductor process may be from +5 mV to +50 mV. The zeta potential may be greater than or equal to +10 mV. The zeta potential may be +40 mV or less.

The zeta potential of the polishing particle may be +5 mV to +50 mV. The zeta potential may be +10mV or more. The zeta potential may be +40 mV or less.

In such cases, the polishing composition may exhibit stable dispersion, thereby suppressing the occurrence of defects on the polished surface due to agglomeration of the polishing particles. Furthermore, the polishing composition may exhibit excellent polishing properties on silicon oxide films having negatively charged surface.

### Composition of the Polishing Composition

### Polishing particle

The polishing composition may include a polishing particle.

The polishing particle may include a metal oxide particle and/or a silicon oxide particle. The polishing particle may include silica. The polishing particle may include colloidal silica.

The polishing particle may include at least 70 wt% of colloidal silica.

The polishing particle may include at least 80 wt% of colloidal silica. The polishing particles may include at least 90 wt% of colloidal silica. The polishing particles may be colloidal silica.

The polishing particle may have a positively charged surface. The polishing particles may have a modified surface having positive charge. The polishing particle may have modified surface with a compound having an amine group. The polishing particle may have modified surface with an amino silane.

For example, the amino silane may be any one selected from the group consisting of 3-aminopropyltriethoxysilane, bis[(3-triethoxysilyl)propyl]amine, 3-aminopropyltrimethoxysilane, bis[(3- trimethoxysilyl)propyl]amine, 3-aminopropylmethyldiethoxysilane, 3-aminopropylmethyldimethoxysilane, N-[3-(trimethoxysilyl)propyl]ethylenediamine, N-bis[3-(trimethoxysilyl)propyl]-1,2-ethylenediamine, N-[3-(triethoxysilyl)propyl]ethylenediamine, diethylenetriaminopropyltrimethoxysilane, diethylenetriaminopropylmethyldimethoxysilane, diethylaminomethyltriethoxysilane, diethylaminopropyltrimethoxysilane, diethylaminopropyltriethoxysilane, dimethylaminopropyltrimethoxysilane, N-[3-(trimethoxysilyl)propyl]butylamine, and combinations thereof.

The polishing composition for a semiconductor process may include the amino silane of 15 ppm (by weight) to 200 ppm (by weight). The polishing composition for a semiconductor process may include the amino silane of 20 ppm (by weight) or more. The polishing composition for a semiconductor process may include the amino silane of 25 ppm (by weight) or more. The polishing composition for a semiconductor process may include the amino silane of 30 ppm (by weight) or more. The polishing composition for a semiconductor process may include the amino silane of 150 ppm (by weight) or less. The polishing composition for a semiconductor process may include the amino silane of 100 ppm (by weight) or less. The polishing composition for a semiconductor process may include the amino silane of 70 ppm (by weight) or less. The polishing composition for a semiconductor process may include the amino silane of 50 ppm (by weight) or less. In these cases, the polishing composition may have a better polishing rate on the silicon oxide film, polish the substrate surface to be polished more smoothly, and exhibit improved dispersibility. At the same time, when a residue of the surface modifier is generated, it may effectively inhibit the adsorption of the residue to surface to be polished.

The polishing composition for a semiconductor process may include the polishing particle of 1 wt% to 10 wt%. The polishing composition for a semiconductor process may include the polishing particle of 2 wt% or more. The polishing composition for a semiconductor process may include the polishing particle of 8 wt% or less. The polishing composition for a semiconductor process may include the polishing particle of 5 wt% or less. In such cases, the polishing composition may have an excellent polishing rate on surface to be polished while reliably inhibiting agglomeration of the polishing particle.

The polishing particle may have an average particle diameter of 20 nm or more. The average particle diameter may be 30 nm or more. The average particle diameter may be 40 nm or more. The average particle diameter may be 70 nm or less. The average particle diameter may be 60 nm or less. The average particle diameter may be 50 nm or less. In such cases, the polishing composition may exhibit a good polishing rate for surface to be polished while stably controlling the frequency of defects on polished surface.

The average particle diameter means the average particle diameter of the primary particle of the polishing particle.

### Corrosion Inhibitor

The corrosion inhibitor of the present disclosure includes a first corrosion inhibitor that is an amino azole-based compound; and a second corrosion inhibitor that is a diazole-based compound.

When the polishing composition includes the first corrosion inhibitor, which is an aminoazole-based compound, and the second corrosion inhibitor, which is a diazole-based compound, the corrosion resistance of the tungsten film to acidic polishing composition may be improved more effectively. This is believed to be because when the first corrosion inhibitor and the second corrosion inhibitor are applied together in the polishing composition, the combination of corrosion inhibitors provides more dense protection on the surface of the tungsten film, reducing the amount of tungsten film surface exposed to the polishing composition.

The first corrosion inhibitor is an azole-based compound including at least one amine group as a functional group. An azole is a five-membered cyclic hetero compound including one nitrogen and one or more non-carbon atoms in the ring.

The first corrosion inhibitor may be aminoimidazole, aminopyrazole, aminotriazole, aminotetrazole, aminooxazole, aminoisoxazole, aminooxadiazole, aminothiazole, aminoisothiazole, aminothiadiazole, or combinations thereof.

The second corrosion inhibitor is a diazole-based compound. A diazole is a five-membered ring including three carbons and two nitrogens in the ring. The second corrosion inhibitor differ from the first corrosion inhibitor in that the second corrosion inhibitor does not include an amine group.

The second corrosion inhibitor may be any one selected from the group consisting of imidazole, pyrazole, and combinations thereof.

The polishing composition for a semiconductor process may include the corrosion inhibitor of 0.07 wt% to 3 wt%. The polishing composition for a semiconductor process may include the corrosion inhibitor of 0.09 wt% or more. The polishing composition for a semiconductor process may include the corrosion inhibitor of 2 wt% or less. The polishing composition for a semiconductor process may include the corrosion inhibitor of 1 wt% or less. In these cases, the degree of damage to the tungsten film caused by the chemical reaction between the polishing composition and the tungsten film during the polishing process may be effectively reduced.

In the polishing composition for a semiconductor process, a ratio of the second corrosion inhibitor content (by weight) to the first corrosion inhibitor content (by weight) may be 0.6 to 2.0. The ratio may be greater than or equal to 0.8. The ratio may be 1.6 or less. In such cases, oxidation of the tungsten during the polishing process may be more effectively inhibited.

The polishing composition for a semiconductor process may include the first corrosion inhibitor of 0.01 wt% to 0.2 wt%. The polishing composition for a semiconductor process may include the first corrosion inhibitor of 0.02 wt% or more. The polishing composition may include the first corrosion inhibitor of 0.04 wt% or more. The polishing composition may include the first corrosion inhibitor of 0.1 wt% or less.

The polishing composition may include the second corrosion inhibitor of 0.01 wt% to 0.2 wt%. The polishing composition may include the second corrosion inhibitor of 0.02 wt% or more. The polishing composition may include the second corrosion inhibitor of 0.04 wt% or more. The polishing composition may include the second corrosion inhibitor of 0.1 wt% or less.

In these cases, the deterioration of tungsten wiring due to corrosion may be more reliably controlled.

### A fluorine-based surfactant

In the present disclosure, a fluorine-based surfactant may be applied to the polishing composition for a semiconductor process. The surfactant may adhere to the surface of organic particles generated during the polishing process, thereby inhibiting the adsorption of the particles to the tungsten film or silicon oxide film surface. Furthermore, the surfactant may be attached to the surface of the silicon oxide film to prevent a polishing particle from adsorbing on the surface of the silicon oxide film and forming scratches on the surface of the silicon oxide film.

The fluorine-based surfactant may be a fluoroalkyl alkylene oxide-based compound. The fluorine-based surfactant may be a compound according to Formula 1 below.

[Formula 1] R_{f}-(Rₑₙ-O)ₙ-H

In Formula 1 above, R_{f} is a fluoroalkyl group having a carbon number of 3 to 10, Rₑₙ is an alkylene group having a carbon number of 2 or 3, and n is an integer of 2 to 15.

In Formula 1 above, R_{f} may be a perfluoroalkyl group having a carbon number of 3 to 10.

The fluorine-based surfactant may be a polymeric surfactant. The fluorine-based surfactant may have a weight average molecular weight of 150 g/mol to 3,000 g/mol. The weight average molecular weight may be 300 g/mol or more. The weight average molecular weight may be greater than or equal to 500 g/mol. The weight average molecular weight may be 2,500 g/mol or less. The weight average molecular weight may be 2,000 g/mol or less. The weight average molecular weight may be 1,500 g/mol or less.

A fluorine-based surfactant with the above characteristics may have a controlled main chain length, which may allow for efficient expulsion of organic particles. In addition, the surfactant may prevent excessive deterioration of the dispersibility of the polishing composition.

The weight average molecular weight of the polymeric surfactant is measured by gel permeation chromatography (GPC).

In the present disclosure, the content of the fluorine-based surfactant may be adjusted to within a predetermined range. This may inhibit the adhesion of organic particles to the polished surface, while preventing excessive foaming of the polishing composition during the polishing process, which may result in poor processability.

The polishing composition for a semiconductor process may include the fluorine-based surfactant of 10 ppm (by weight) or more. The polishing composition for a semiconductor process may include the fluorine-based surfactant of 20 ppm (by weight) or more. The polishing composition for a semiconductor process may include the fluorine-based surfactant of 50 ppm (by weight) or more. The polishing composition for a semiconductor process may include the fluorine-based surfactant of 100 ppm (by weight) or more. The polishing composition for a semiconductor process may include the fluorine-based surfactant of 150 ppm (by weight) or more. The polishing composition for a semiconductor process may include the fluorine-based surfactant of 500 ppm (by weight) or less. The polishing composition for a semiconductor process may include the fluorine-based surfactant of 450 ppm (by weight) or less. This may effectively increase the hydrophilicity of the polishing pad debris while inhibiting excessive foaming during the polishing process.

### Other Additive

The polishing composition for a semiconductor process may further include an additive. The additive may be one commonly applied in the field of CMP. For example, the additive may be at least one of an oxidizing agent, an acid component, a pH adjuster, a chelating agent, a dispersant, a polishing rate enhancer, a polishing regulator, a polishing pad protectant, and a preservative.

The polishing composition for a semiconductor process may further include an oxidizing agent. The oxidizing agent may oxidize the metal, such as tungsten, to create an environment that more readily levels the substrate surface and improves polishing rate and etching rate.

The oxidizer may be one selected from the group consisting of hydrogen peroxide, urea peroxide, urea, percarbonate, periodic acid, periodate, perchloric acid, perchlorate, perbromic acid, perbromate, perboric acid, perborate, permanganic acid, permanganate, persulfate, bromate, chlorate, chlorite, chromate, iodate, iodic acid, ammonium persulfate, benzoyl peroxide, calcium peroxide, barium peroxide, sodium peroxide, and combinations thereof.

The polishing composition for a semiconductor process may include the oxidizing agent of 0.01 wt% to 5 wt%. In such cases, the composition may exhibit good polishing properties to the metal and may inhibit the formation of an oxide film on the metal to be polished during the polishing process.

The polishing composition for a semiconductor process may further include an acid component. For example, the acid component may be at least one selected from the group consisting hydrochloric acid, phosphoric acid, sulfuric acid, hydrofluoric acid, bromic acid, iodic acid, formic acid, malonic acid, maleic acid, oxalic acid, acetic acid, , citric acid, adipic acid, propionic acid, fumaric acid, lactic acid, salicylic acid, pimelin, benzoic acid, succinic acid, phthalic acid, butyric acid, glutaric acid, glutamic acid, glutamine acid, glycolic acid, asparagine acid, tartaric acid, and salts thereof.

The polishing composition for a semiconductor process may further include a pH adjuster in addition to the acid component. The pH adjuster may be, for example, any one selected from the group consisting of ammonia, aminomethylpropanol, tetramethylammonium hydroxide, potassium hydroxide, sodium hydroxide, magnesium hydroxide, rubidium hydroxide, cesium hydroxide, sodium bicarbonate, sodium carbonate, and combinations thereof.

The polishing composition for a semiconductor process may include a chelating agent. The chelating agent may prevent polished metal particles from absorbing on the surface of a polished surface.

The chelating agent may include two or more carboxylic or alcoholic groups. Two or more types of chelating agents, each comprising two or more carboxyl groups or alcohol groups may be applied as chelating agents. Specifically, the chelating agent may include any one selected from the group consisting of ethylenediaminetetraacetic acid (EDTA), glycine, carboxylic acids, and combinations thereof. The carboxylic acid means a compound including at least one or more carboxyl groups.

The polishing composition for a semiconductor process may further include a dispersant.

The dispersant may prevent agglomeration and uniformly disperse the polishing particle within the polishing composition. A cationic dispersant may positively increase the zeta potential of the polishing composition, while an anionic dispersant may negatively decrease the zeta potential of the polishing composition.

The dispersant may include anionic small molecule, cationic polymer, organic acid, or the like.

The anionic small molecule of the dispersant may be one or more selected from oxalic acid, citric acid, polysulfonic acid, polyacrylic acid, polymethacrylic acid, and combinations thereof.

The cationic polymer as the dispersant may be one or more selected from polylysine, polyethyleneimine, benzethonium chloride, bronidox, cetrimonium bromide, cetrimonium chloride, dimethyldioctadecylammonium chloride, tetramethylammonium hydroxide, distearyldimethylammonium chloride, polyarylamine, and combinations thereof.

The organic acid as the dispersant may be one or more selected from hydroxylbenzoic acid, ascorbic acid, picolinic acid, glutamic acid, tryptophan, aminobutyric acid, and combinations thereof.

The polishing rate enhancer is an additive for increasing the polishing rate for a substrate or a wiring to be polished, and may be one or more selected from potassium nitrate, iron nitrate, ammonium hydroxide, citric acid, acetic acid, and combinations thereof.

The polishing regulator may minimize adsorption of the polishing composition to the metal surface and may include at least one selected from the group consisting ammonium compound, potassium nitrate, amino acid, or salts thereof.

The polishing composition for a semiconductor process may include a solvent. The solvent may be water, and more particularly may be ultrapure water.

### Polishing Properties of Polishing Composition

The polishing rate for the silicon oxide film of the polishing composition for a semiconductor process may be 800 Å/min or more. The polishing rate may be 1000 Å/min or more. The polishing rate may be 1100 Å/min or more. The polishing rate may be 3000 Å/min or less. The polishing rate may be 2500 Å/min or less. The polishing rate may be 2000 Å/min or less.

The polishing rate for the tungsten film of the polishing composition for a semiconductor process may be 50 Å/min or more. The polishing rate may be 70 Å/min or more. The polishing rate may be 500 Å/min or less. The polishing rate may be 300 Å/min or less. The polishing rate may be 200 Å/min or less.

The polishing selectivity ratio of the silicon oxide film to the tungsten film of the polishing composition for a semiconductor process may be 5 or more. The polishing selectivity ratio may be 6 or more. The polishing selectivity ratio may be 7 or more. The polishing selectivity ratio may be 20 or less.

In such cases, the polishing composition may exhibit a good silicon oxide polishing rate relative to the tungsten polishing rate.

The Ra value of the tungsten film measured after 30 seconds of polishing with the polishing composition for a semiconductor process may be 3 nm or less. The Ra value may be 2 nm or less. The Ra value may be 1.5 nm or less. The Ra value may be 1 nm or less. The polishing composition having these characteristics may provide tungsten films that are less damaged by corrosion when applied to polishing.

Ra values are measured with an Atomic Force Microscope (AFM) based on ISO 4287.

Polishing for each thin film is performed at a pressure of 2.2 psi, carrier speed of 87 rpm, platen speed of 93 rpm, and slurry flow rate of 250 ml/min. The polishing pad may be SR-300 model from SK enpulse Co., Ltd.

When measuring the polishing rate for each thin film, a polishing machine may be used, for example, the AP-300 model from CTS.

### Method of Manufacturing a Substrate

In the present disclosure, a method of manufacturing a substrate includes polishing the substrate by applying the polishing composition for a semiconductor process as a slurry.

The substrate may include at least one selected from the group consisting of an insulating film, a metal wiring, and a barrier layer on the top surface. The metal wiring may include copper or tungsten. If the metal wiring comprises copper, the barrier layer may include tantalum or nitrides thereof. If the metal wiring comprises tungsten, the barrier layer may include titanium or nitrides thereof.

Specifically, the process of polishing a substrate may be performed by contacting the substrate to be polished with the polishing composition for a semiconductor process supplied from a spray nozzle onto a polishing pad, while the polishing head holding the substrate may be rotated and the platen to which the polishing pad is attached may be also rotated.

The process of polishing the substrate may further comprise, if desired, conditioning the surface of the polishing pad prior to polishing.

The polishing composition for a semiconductor process may polish the substrate that come into contact with the polishing pad while penetrating the substrate.

In the process of polishing the substrate, a pressure of 6.89 kPa to 48.26 kPa may be applied. The pressure may be from 13.79 kPa to 34.47 kPa.

The process of polishing the substrate may be performed for 50 seconds to 10 minutes. However, this may vary depending on the target degree of polishing.

The description of the polishing composition for a semiconductor process is redundant to the foregoing and is therefore omitted.

The method of manufacturing the substrate may further include a cleaning process to clean the polished substrate.

The cleaning process may be carried out by flushing the polished substrate through purified water and drying with inert gas.

Specific embodiments will be described in more detail below. The following embodiments are illustrative only to aid in understanding the disclosure and are not intended to limit the scope of the invention.

### Manufacturing Example: Preparation of Polishing Composition

Example 1: In ultrapure water as solvent, 3 wt% of colloidal silica having modified surface with (3-aminopropyl)triethoxysilane at a concentration of 38 ppm (by weight) as a polishing particle, 0.05 wt% of aminotetrazole as the first corrosion inhibitor, 0.05 wt% of imidazole as the second corrosion inhibitor, 20 ppm (by weight) of Capstone's FS 3100 as the fluorine-based surfactant, 1 wt% of sorbitol and 2 wt% of sucrose as the pad protectant, were added and mixed to prepare a total polishing composition of 100 wt%.

Comparative Example 1: A total of 100 wt% polishing composition was prepared under the same conditions as Example 1 except that only 0.05 wt% aminotetrazole was applied as the corrosion inhibitor and 2 wt% sorbitol as the pad protectant, and the average particle size of the polishing particle, pH, electrical conductivity, and zeta potential of the polishing composition were applied as shown in Table 2.

Comparative Example 2: A total of 100 wt% polishing composition was prepared under the same conditions as Example 1, except that no corrosion inhibitor was applied, 2 wt% sorbitol was applied as the pad protectant, and the average particle size of the polishing particle, pH, electrical conductivity, and zeta potential of the polishing composition were applied as shown in Table 2.

In the polishing compositions of the Example and Comparative Examples, the content of each component and the particle average diameter (primary particle size) of the polishing particle are shown in Table 1 below, and the pH, electrical conductivity, and zeta potential of the polishing composition are shown in Table 2 below.

### Evaluation Example: Static Etch Rate Measurement

The substrate on which the tungsten film was formed was immersed in the polishing compositions of each Example and Comparative Example for 10 minutes. The difference between the thickness of the tungsten film before and after immersion was then measured, and the difference was divided by the immersion time to calculate the static etch rate.

The static etch rates for the Example and Comparative Examples are shown in Table 2 below.

### Evaluation Example: Measuring Corrosion-Related Properties

The corrosion current density I_{corr} and corrosion potential E_{corr} for the tungsten films of the polishing compositions of the Example and Comparative Examples were measured with a versaSTAT 4 Potentiostat from AMETEK Scientific instruments. The measurement conditions were set as follows
- Reference Electrode: SCE Saturated Calomel (saturated KCl)
- Working Electrode Type: Solid Tungsten Electrode
- RED Speed: 0 volt
- Working Electrode Area: 1cm²
- Measured Open Circuit: 131.27mV

### Endpoint Properties

- Initial Potential: -1.5V (vs OC)
- Final Potential: 4V (vs Ref)

### Scan Properties

- Step Height: 10mV
- Step Time: 1s
- Smay Rate: 10mV/s
- Total Points: 551

The measurements and calculations for each Example and Comparative Example are listed in Table 2 below.

### Evaluation Example: Measuring Polishing Characteristics and Detecting Defects

The polishing composition was applied, and the top surface of the 300 mm diameter wafer was polished on a CTS AP-300 polishing machine.

The polishing was performed at a polishing time of 60 seconds, pressure of 2.2 psi, carrier speed of 93 rpm, platen speed of 87 rpm, and slurry flow rate of 300 ml/min.

The wafer consisted of a tungsten pattern with a pattern density of 50% embedded in a silicon oxide film.

After polishing, the silicon oxide film thickness difference and the tungsten film thickness difference before and after polishing were measured to calculate the polishing rate for each thin film and the polishing selectivity ratio of the silicon oxide film to the tungsten film.

The number of defects detected on the silicon oxide film was then measured using Tenkor's XP+ defect measurement equipment.

In addition, the Ra value of the tungsten film after polishing was measured by Atomic Force Microscopy (AFM) according to ISO 4287.

The measurements for each Example and Comparative Example are listed in Table 3 below.

### Evaluation Example: Measuring Bubble Generation

3 L of the polishing composition for each Example and Comparative Example was added to a glass reactor with a volume of 5 L. The polishing composition was stirred at a speed of 1,000 RPM for 30 minutes at 25°C with a 4-lobed blade with a total length of 10 cm. Ten minutes after the end of stirring, the height of the bubbles formed in the glass reactor was measured. The volume of the bubbles was calculated from the height value and the inside diameter of the glass reactor containing the polishing composition.

The calculated bubble volume values for the Example and Comparative Examples are shown in Table 3 below.

**[Table 1]**

| | A polishin g particle Content (wt%) | Average Diameter of A polishing particle (nm) | Corrosion Inhibitors | | | A fluorine-based surfactant (ppm, by weight) | Pad Protectant | |
|---|---|---|---|---|---|---|---|---|
| | | | Aminote trazole (wt%) | Imidazole (wt%) | Total (wt%) | | Sorbitol (wt%) | Sucrose (wt%) |
| Example 1 | 3 | 44.92 | 0.05 | 0.05 | 0.1 | 20 | 1 | 2 |
| Comparativ e Example 1 | 3 | 44.55 | 0 | 0.05 | 0.05 | 20 | 2 | 0 |
| Comparativ e Example 2 | 3 | 44.42 | 0 | 0 | 0 | 20 | 2 | 0 |

**[Table 2]**

| | Static Etch Rate (Å/min) | I_{corr} (µA/cm²) | E_{corr} (mV) | pH | Electrical Conductivity (µS/cm) | Zeta Potential (eV) |
|---|---|---|---|---|---|---|
| Example 1 | 3.81 | 17 | -12 | 4.01 | 111.4 | 22.4 |
| Comparative Example 1 | 2.42 | 92 | +24 | 4.05 | 112.1 | 21.7 |
| Comparative Example 2 | 9.22 | 71 | +32 | 3.96 | 62.7 | 22.5 |

**[Table 3]**

| | Polishing Rate of Tungsten Films (Å/min) | Polishing Rate for Silicon Oxide Films (Å/min) | Polishing Selectivity Ratio of Silicon Oxide Films on Tungsten Films | Ra of Tungsten Films (nm) | Bubble Volume (ml) |
|---|---|---|---|---|---|
| Example 1 | 130 | 1109 | 8.53 | 0.96 | 20 |
| Comparative Example 1 | 143 | 1129 | 7.90 | 1.16 | 20 |
| Comparative Example 2 | 152 | 1281 | 8.43 | 1.36 | 20 |

From Table 2, it may be seen that Example 1 had a lower corrosion potential value and a lower corrosion current density compared to Comparative Examples 1 and 2. In other words, Example 1 had a faster onset of corrosion compared to Comparative Examples 1 and 2, but a smaller amount of corrosion.

For the static etch rate, Example 1 showed values below 4 Å/min, while Comparative Example 2 showed values above 9 Å/min.

This means that in Example 1 with two corrosion inhibitors, the rate of corrosion was significantly slower when the polishing composition was in contact with the tungsten film compared to the polishing composition in Comparative Example 2.

With respect to the Ra value of the tungsten film, Example 1 showed a lower value compared to the Comparative Examples. This means that when polishing with the composition of Example 1, the tungsten film was less damaged by corrosion than in the Comparative Examples.

For the bubble volume, both the Example and Comparative Examples showed a value of 20 mL. This indicates that the application of surfactants in the polishing composition did not cause excessive foaming during the polishing process.

Although preferable embodiments of the present disclosure have been described above in detail, the scope of the present disclosure is not limited thereto, and various modifications and improvements made by those skilled in the art using the basic concepts of the present disclosure also belong to the scope of the present disclosure.

## Claims

1. A polishing composition for a semiconductor process, comprising
a polishing particle; and a corrosion inhibitor,
wherein the corrosion inhibitor comprises a first corrosion inhibitor, which is an amino azole-based compound; and a second corrosion inhibitor, which is a diazole-based compound,
wherein the polishing composition for a semiconductor process has a pH of 2 to 5, and
a static etch rate for a tungsten film of the polishing composition for a semiconductor process is 6 Å/min or less.

2. The polishing composition for a semiconductor process of claim 1,
I_{corr}, which is a corrosion current density for a tungsten film of the polishing composition for a semiconductor process is 60 µA/cm² or less.

3. The polishing composition for a semiconductor process of claim 1,
E_{corr}, which is a corrosion potential for a tungsten film of the polishing composition for a semiconductor process is -30 mV or more.

4. The polishing composition for a semiconductor process of claim 1,
comprising the corrosion inhibitor of 0.07 wt% to 3 wt%.

5. The polishing composition for a semiconductor process of claim 1,
wherein a ratio of a content (by weight) of the second corrosion inhibitor to a content (by weight) of the first corrosion inhibitor is 0.6 to 2.0.

6. The polishing composition for a semiconductor process of claim 1,
wherein the corrosion inhibitor inhibits corrosion of a tungsten film.

7. The polishing composition for a semiconductor process of claim 1,
further comprising a fluorine-based surfactant of 10 ppm (by weight) to 500 ppm (by weight).

8. The polishing composition for a semiconductor process of claim 1,
a polishing selectivity ratio of a silicon oxide film to a tungsten film of the polishing composition for a semiconductor process is 5 or more.

9. A method of manufacturing a substrate, comprising polishing a substrate by applying the polishing composition for a semiconductor process of claim 1 as a slurry.
